# EUROPEAN PATENT APPLICATION

(11) **EP 2 413 165 A1**
(43) Date of publication of application: **01.02.2012**
(21) Application number: 10170800.6
(22) Date of filing: 26.07.2010
(51) Int. Cl.: G01V 8/20, H05K 5/06

(54) **Watertight enclosure with an open profile covered by a plate**

(71) Applicant: Optosys SA, 1762 Givisiez (CH)
(72) Inventor: Bochud, Roland, CH-1757, Noréaz (CH); Rhême, Charles, CH-1725, Posieux (CH); Heimlicher, Peter, CH-1700, Fribourg (CH)
(74) Representative: AMMANN PATENTANWÄLTE AG BERN

(57) **Abstract**

An enclosure (1) comprising a hollow profile (2) with an open side portion on which a covering plate (3) is watertightly attached, the profile (2) being provided with at least one end closure (4) comprising a watertight sealing (41) disposed at the end of the profile (2).

In order to improve the waterproof properties, in particular for an electronic enclosure, by keeping constructional modifications on the enclosure as low as possible, a jamming member (40) is provided inside the sealing (41), the jamming member (40) being adapted to exert a pressing force on at least two opposed side portions (71-76) of the sealing (41) acting in a transverse direction (92, 93) with respect to a plate-adjoining side (48) of the sealing (41) which is disposed adjacent to the covering plate (3).

## Description

The invention relates to an enclosure comprising a hollow profile with an open side portion on which a covering plate is watertightly attached, the profile being provided with at least one end closure comprising a watertight sealing disposed at the end of the profile, according to the preamble of claim 1. In particular, but not exclusively, the invention relates to a device comprising such an enclosure as a housing for electronic and/or optical equipment such as a light barrier.

Common profiles of that type are typically formed by an extrusion process, in particular from aluminium or a similar material, and often exhibit an essentially U-shaped cross section. Before or after arranging electronic components or other material in the cavity of the profile, the open side portion of the profile is covered by a plexiglass-plate or the like. The covering plate can be attached to the profile by adhesive means generally known in the art in a highly waterproof manner. In this way, an ingress protection rating (IP) for electronic enclosures, as defined by the international standard IEC 60529, with a value of 65 or better can be achieved with respect to the lateral attachement of the covering plate to the profile.

More critical is to ensure a desired value of water tightness of the enclosure at the end sections of the profile. For this purpose, a sealing loop of caoutchouc or similar unaccomodating and watertight material is usually disposed around the end section of the profile. The sealing loop is firmly pressed against the end section by a capping member tightly attached to the profile's end. In this way, a watertight end closure of the profile is provided by the capping member and the sealing loop embedded therein. This end closure, however, represents the highest potential danger of water intrusion problems and consequently, in the case of an electronic enclosure, reduces the desired level of watertightness dramatically.

It is therefore an object of the present invention to provide the initially mentioned enclosure with improved waterproof properties by keeping constructional modifications on the enclosure as low as possible and/or allowing an easy fabrication or assembly of such an enclosure by avoiding at least one of the above mentioned disadvantages.

At least one of these objects is achieved with an enclosure comprising the features of patent claim 1. Advantageous embodiments of the invention are defined by the dependent claims.

Accordingly, the invention suggests that a jamming member is provided inside the sealing, the jamming member being adapted to exert a pressing force on at least two opposed side portions of the sealing acting in a transverse direction with respect to a side portion of the sealing which is disposed adjacent to the covering plate and subsequently referred to as plate-adjoining side of the sealing.

The present invention originates from the observation that a weak point with respect to the watertightness of the enclosure are the portions of the sealing at which the attachment of the covering plate on the profile is adjoined. It has been found that an arrangement of a jamming member in the above described manner leads to an unexpected strong improvement of the watertightness and constitutes a surprisingly effective remedy with respect to the intrinsic deficiencies of this particular problematic region. In this way, the overall waterproof characteristics of the whole enclosure may be substantially improved. By way of example, an IP value of 65 or better may be obtainable for the profile used as an electronic enclosure.

The invention will be described in more detail in the following description of a preferred exemplary embodiment with reference to the accompanying drawings. In the drawings:
- Fig. 1: is a perspective view of an electronic enclosure according to the invention;
- Fig. 2: is a front view of the profile's end section of the electronic enclosure shown in Fig. 1;
- Fig. 3: is an exploded view of the electronic enclosure shown in Fig. 1;
- Fig. 4: is another exploded view of the end closure of the electronic enclosure shown in Fig. 3 from a different viewpoint;
- Fig. 5: is the front view of the profile's end section shown in Fig. 2, wherein parts of the end closure are mounted on the end section;
- Fig. 6: is a detail of a longitudinal sectional view according to VI-VI of the profile shown in Fig. 5;
- Fig. 7: is a cross-sectional view of the profile's end section with the parts of the end closure as shown in Fig. 5, wherein a capping member has been mounted on the profile; and
- Fig. 8: is a detail of a longitudinal sectional view according to VIII-VIII of the profile shown in Fig. 7.

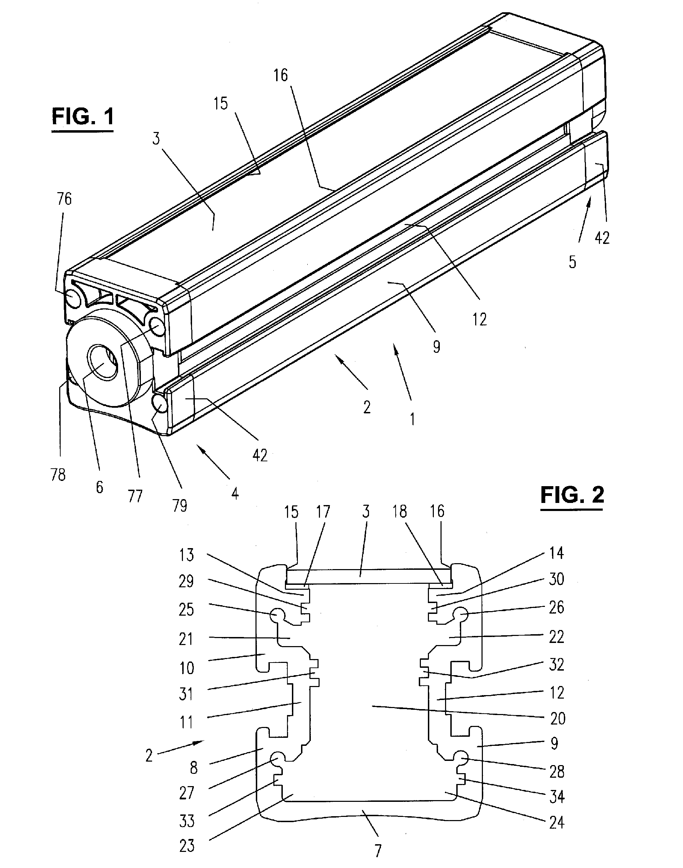

Fig. 1 shows an electronic enclosure 1 comprising a hollow profile 2 with an open side portion on which a covering plate 3 is watertightly attached. The profile 2 is extruded from metallic material and the covering plate 3 consists of synthetic material. The watertight sealing mechanism described below is particularly suited for an enclosure 1 comprising these materials. It is understood, however, that also other materials are conceivable. At both ends of the profile 2 an end closure 4, 5 is mounted in a watertight manner. The end closure 4 comprises a central opening 6 that is designed for a protruding component or cable of an optoelectronic device that is to be protected inside the cavity of the profile. In this particular case, the central opening 6 is provided for housing of a light emitting end portion or a cable of a light barrier, wherein the more sensitive opto-electronic components of the device are arranged inside the cavity of the profile 2. End closure 5 is similar to end closure 4 except that the central opening 6 is absent.

As best seen in Fig. 2, depicting a front view of the end section 10 of the profile 2 without the end closure 4, the profile 2 has a substantially U-shaped structure comprising a floor side 7 and two opposed lateral sides 8, 9. The lateral sides 8, 9 are each provided with a substantially rectangular indentation 11, 12 at their center portion. The length of the indentations corresponds to approximately one third of the total length of the lateral sides 8, 9.

The mid portion of the upper third of each lateral side 8, 9 is provided with a carrier protrusion 13, 14. The upper surface of the carrier protrusions 13, 14 is used as a support for the covering plate 3. In this way, the covering plate 3 is arranged in between the upper inner edges of the lateral sides 8, 9 of profile 2. The covering plate 3 along its two exterior longitudinal sides 15, 16 is attached to the carrier protrusions 13, 14 by a double-sided adhesive tape 17, 18. Other kinds of attachments are also conceivable, e.g. silicone, glue, etc.

Thus, on both sides of the cavity 20 of the profile 2, more precisely in between each of the respective indentations 11, 12 and the carrier protrusions 13, 14, an upper side compartment 21, 22 is formed in the cavity 20. Moreover, two lower side compartements 23, 24 are formed in the cavity 20 below the respective indentations 11, 12.

Each of the lower portions of the indentations 11, 12 and of the carrier protrusions 13, 14 are provided with a circular shaped groove 25-28 each bordering into one of the side compartments 21-24 and extending in the longitudinal direction of the profile 2. The end portions of these circular grooves are used as boreholes 25-28 for the fixation of the end closures 4, 5. Furthermore, three longitudinaly extending and rectangular shaped inner grooves 29-34 are provided on each of the lateral sides 8, 9, which may serve e.g. as fixation rails for electronic equipment inside the cavity 20.

By means of the attachments 17, 18 generally known in the art, a high-grade waterproof protection is provided in the length direction of the profile 2. On the profile's end section in common enclosures, however, the attachements 17, 18 may constitute a leak-prone region at least in the case the enclosure is exposed to splashing water, water jets or similar demands. In the electronic enclosure 1 these shortcomings have been remedied according to the subsequent description.

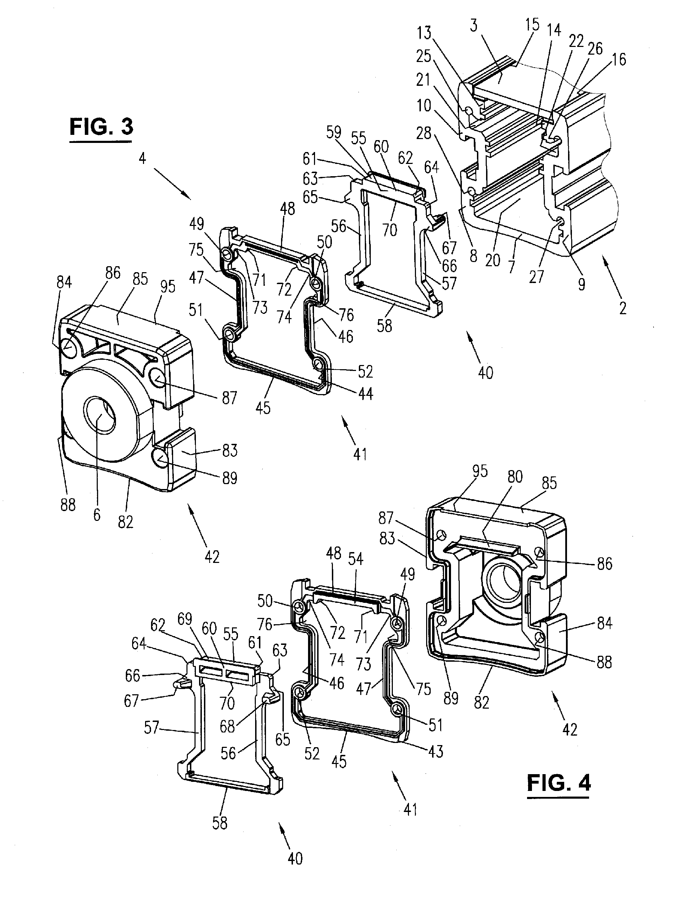

Fig. 3 depicts the enclosure 1 in an exploded view. The end closure 4 of enclosure 1 is composed of three separate pieces, namely a jamming member 40, a sealing loop 41 and a capping member 42. A corresponding exploded view of the end closure 4 from a different angle is shown in Fig. 4.

The sealing loop 41 consists of an elastic material which is substantially incompressible, e.g. a water-impermeable rubber material such as e.g. NBR 50 Share A, and has an outer circumference resembling the end section 10 of profile 2. In particular, a sealing lip 43 projecting on the face side of sealing loop 41 is matched to the shape of end section 10 (see Fig. 4). A corresponding sealing lip 44 projecting on the back side of sealing loop 41 substantially exhibts the same form.

Accordingly, with respect to the arrangement of the sealing loop 41 at the end section 10, the sealing loop 41 is composed of a bottom side 45 adjoining the floor side 7 of the end section 10, two opposed lateral sides 46, 47 adjoining the lateral sides 8, 9 of the end section 10, and an upper plate-adjoining side 48 that is adjacent to the covering plate 3.

The sealing loop 41 further comprises four circular openings 49-52 that are disposed at the corresponding positions with respect to the boreholes 25-28 at the end section 10 of profile 2. On both sides of the sealing loop 41, the circular openings 49-52 are surrounded by a circular projection which is seamlessly integrated into the course of the respective sealing lip 43, 44.

On the front of sealing loop 41, the plate-adjoining side 48 is provided with a front protrusion 54 exceeding the height of the sealing lips 43, 44 (see Fig. 4). The size of the front protrusion 48 matches the distance between the carrier protrusions 13, 14 of the end section 10 of profile 2 and thus is adapted to be inserted into the cavity 20 of profile 2 for adjoining the covering plate 3 from the bottom side.

The inner circumference of sealing loop 41 is adapted to the shape of the outer circumference of jamming member 40. The jamming member 40 is substantially rigid and is preferably composed of synthetic material. It has a frame-like structure roughly matching the shape of sealing loop 41, wherein the upper side 55, the two lateral sides 56, 57 and the bottom side 58 have a smaller length dimension, respectively. The thickness of the jamming member 40 essentially corresponds to the thickness of the sealing loop 41.

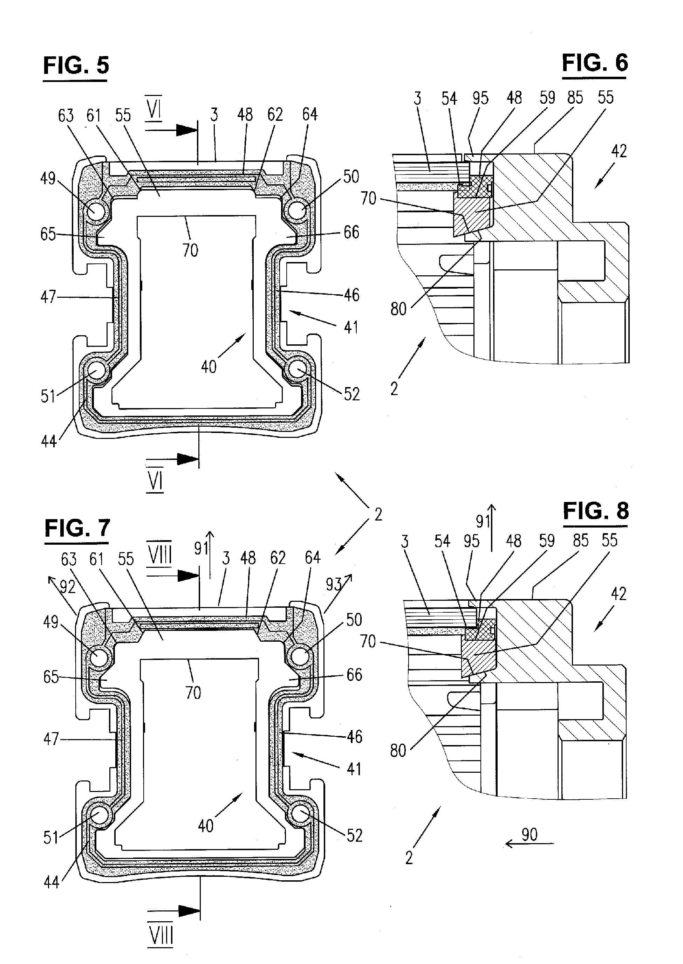

On the upper side 55 of the jamming member 40 an upper protrusion 60 is provided. On both sides of the upper protrusion 60, upper tapering portions 61, 62 are formed. The upper tapering portions 61, 62 substantially have a circular shaped cross-section. On both lateral end portions of the upper side 55, two additional lower tapering portions 63, 64 are formed exhibiting a curved shaped cross-section (see Fig. 5).

The upper side portions of the opposed lateral sides 56, 57 of the jamming member 40 are provided with outer lateral projections 65, 66. The lower edge of the lateral projections 65, 66 protrudes orthogonally from the lateral sides 56, 57. The upper edge exhibits a linear slope with respect to the plate-adjoining side 48 of the sealing ring 41. Thus, each of the lateral projections constitutes a lateral tapering portion 65, 66.

Overall, the upper taperings 61, 62, the lower taperings 63, 64 and the lateral taperings 65, 66 are configured in a step like arrangement on both sides of the jamming member 40, wherein the lateral distance between respective tapering portions 61-66 decreases towards the top of the jamming member 40. Thus, the upper side of jamming member 40 constitutes a bridging portion 55 in between the taperings 61-66 arranged on the opposed sides of the jamming member 40.

The sealing loop 41 is provided with corresponding recesses 71-76 adapted to the shapes of the tapering portions 61-66 on the jamming member 40. Thus, the recesses 71-76 have a form, which substantially corresponds to the respective tapering portions 61-66 on jamming member 40. Recess 71, 72 has a linear inclination corresponding to the respective tapering portion 61, 62.

The jamming member 40 further comprises a plugging protrusion 67, 68 on each front side of the lateral projections 65, 66. The plugging protrusions 67, 68 are formed to be inserted into the upper side compartments 21, 22 of the cavity 20 of profile 2. This allows a correct positioning of jamming member 40 at the end section 10 of profile 2 and a first loose fixation. The plugging protrusions 67, 68 are smaller as compared to the height of the side compartments 21, 22 for ensuring a certain mobility of the jamming member 40 in the vertical direction of end section 10 when it is inserted and the capping member 42 is fixed by the screws.

The upper protrusion 60 of the jamming member 40 has a substantially flat upper surface 59 projecting in the front direction of jamming member 40. The side length of the upper protrusion 55 corresponds to the distance between the carrier protrusions 13, 14 of profile 2, allowing an insertion into the cavity 20. In this way, a support for the front protrusion 54 on the sealing loop is formed. The front edge of the upper protrusion 55 is further provided with an elevation as compared to the height of the rest of upper surface 59. The elevation serves as a frontal abuting structure for the sealing ring 41 when the jamming member 40 is positioned inside the sealing ring 41.

The lower surface 70 of the bridging portion 55 also protrudes and exhibits a substantially linear inclination with respect to the length axis of profile 2 (see Fig. 6). The lower surface permits to apply a vertical force on jamming member 40 and therefore is subsequently referred to as application surface 70.

A corresponding linear inclination is formed on a protruding upper surface 80 inside the capping member 42 (see Fig. 4). Also the length and with of the protruding surface 80 substantially corresponds to the application surface 70 of the bridging portion 55 of jamming member 40. The protruding surface 80 serves to transfer a force on the application surface 70 for activating the sealing mechanism and therefore is subsequently referred to as activation surface 80.

The inner side walls of the capping member 42 on its bottom side 82, lateral sides 83, 84 and top side 85 correspond to the shape of the lateral circumference of sealing loop 41. In this way, the sealing loop 41 with the jamming member 40 disposed inside can be fitted into the capping member 42 and a pressing force acting on the inner circumference of the sealing loop 41 is counteracted by the inner side walls of capping member 42. The mid portion of the top side 85 of capping member 42 is provided with an upper front protrusion 95 substantially corresponding to the width of covering plate 3. The upper front protrusion 95 may allow a simplified manual positioning of the capping member 42 during its installation on the end section 10 of profile 2 and may also contribute to the sealing effect. Furthermore, four boreholes 86-89 are provided in the capping member 42 at the corresponding positions as the circular openings 49-52 in the sealing loop 41.

Subsequently the installation and start of operation of the end closure 4 on profile 2 is discussed. At first, the sealing loop 41 is preferably positioned around the end section 10 of profile 2 such that the attachments 15, 16 are fully covered by the plate-adjoining side 48 and the front protrusion 54 ranges into the cavity 20 abuting against the covering plate 3 from below.

As a second step, the jamming member 40 is positioned along the inner circumference of sealing loop 41, such that the plugging protrusions 67, 68 range inside the side compartments 21, 22 of the cavity 20 and the flat protruding upper surface 59 supports the front protrusion 54 of the sealing loop 41.

This configuration is depicted in Fig. 5. As can be seen in this figure, the tapering portions 61-66 of jamming member 40 face the plate-adjoining side 48 of the sealing loop 41 and border on the corresponding recesses 71-76 in the sealing loop 41. The bridging portion 55 directly abuts against the plate-adjoining side 48 of the sealing loop 41. The jamming member 40 is inserted into the cavity 20 in such a way, as best seen in Fig. 6, that its upper elevation on the frontal end of protruding upper surface 59 abuts against the frontal edge of the plate-adjoining side 48 of sealing loop 41.

As a next step, as shown in Fig. 6, the capping member 42 is plugged around the end section 10 with its inner side walls 82-85 bordering the outer circumference of the sealing loop 41. Thus, the inclined activation surface 80 in the capping member 42 is positioned below the inclined application surface 70 of the bridging portion 55 of jamming member 40. At the same time, the upper front protrusion 95 of capping member 42 is positioned on top of the covering plate 3 in between the upper inner edges of the lateral sides 8, 9 of profile 2. In this way, a guiding passage for an advancement of the upper front protrusion 95 in the length direction of profile 2 is provided in between the upper inner edges of the lateral sides 8, 9, facilitating a correct positioning of capping member 42 and the further installation procedure.

Finally, the capping member 42 is tightly fixed on the profile 2 by establishing a screw connection within the boreholes 25-28 and 86-89, respectively. The effect of this screwing operation is shown in Figg. 7 and 8.

As depicted in Fig. 8, the capping member 42 is further advanced towards the profile 2, as indicated by arrow 90. Thus, also the upper front protrusion 95 is further advanced in between the upper inner edges of the lateral sides 8, 9 of profile 2. The advancement of capping member 42 has the effect, that the sealing lips 43 are tightly pressed against the end section 10 of profile 2 and the sealing lips 44 are tightly pressed against the inside of capping member 42.

Additionally, the activation surface 80 of capping member 42 is further progressed along the application surface 70 of the jamming member 40. As a result, an activation force 90 is transmitted to the inclined application surface 70 and a vertical force component is executed on the bridging section 55 of jamming member 40, as indicated by arrow 91. This leads to a slight displacement of the jamming member 40 with respect to the position of sealing loop 41 in the vertical direction. Thus, a pressing force 91 is transmitted from the upper flat surface 59 of the bridging portion 55 to the plate-adjoing side 48 of the sealing loop 41 which in turn is now tightly pressed along its front protrusion 54 against the lower surface of covering plate 3. Furthermore, the upper elevation on the frontal end of protruding upper surface 59 of jamming member 40 is now abuting against the covering plate 3 from below such that the frontal edge of the plate-adjoining side 48 of sealing ring 41 is entirely encompassed by jamming member 40 and covering plate 3.

As shown in Fig. 7, the activation force in the vertical direction 91 and the corresponding displacement of the jamming member 40 has the further effect, that the tapering portions 61-66 of jamming member 40 are tightly pressed against the inclinations in the corresponding recesses 71-76 of the sealing loop 41. In this way, the vertical force 91 acting on jamming member 40 is transmitted at the taperings 61-66 towards the the sealing loop 41 as a force acting in a transverse direction with respect to the position of the plate-adjoing side 48 of the sealing loop 41, as indicated by arrows 92, 93.

These transverse forces 92, 93 acting towards the two opposed sides 46, 47 of the sealing loop 41 lead to a substantial improvement with respect to the water-tightness of the electronic enclosure 1. A particularly pronounced sealing improvement is achieved by the force application through the upper tapering portions 61, 62, which are situated in close proximity to the attachments 15, 16 of the covering plate 3. The additional taperings 63-66 with a larger distance from the attachments 15, 16 may also substantially contribute to the sealing effect.

Numerous alterations of the enclosure described above will suggest themselves to those skilled in the art. However, it is to be understood that the present disclosure relates to a preferred embodiment of the invention which is for purposes of illustration only and is not to be construed as a limitation of the invention.

In particular, various preferred embodiments of the present invention are defined by the dependent claims and comprise for instance the following aspects:
Preferably, the transverse direction of the pressing force comprises a vector component directed towards the plate-adjoining side of the sealing and a vector component in an othogonal direction. Advantageously, the jamming member may be provided with a tapering portion at each of the opposed side portions of the sealing. Each of these tapering portions may face the plate-adjoining side of the sealing. Hence, an inclined or curved surface on a force transmitting portion of the jamming member may be provided for directing the pressing force in the transverse direction with respect to the plate-adjoining side of the sealing. Preferably, this tapering portion has a substantially circular curved form. Alternatively or complementary, also other shapes for a transverse force transmission such as a substantially linear inclination or other curved shapes are conceivable.
Preferably, the tapering portions are disposed in direct proximity to the attachement of the covering plate on the profile. In this way, the impact zone of the jamming member may be situated close to the weak point of the sealing.
Preferably, the distance of at least two of the tapering portions to the attachement is less than one fifth, more preferred less than one tenth of the cross section dimension of the profile. Preferably, the distance of at least two of the tapering portions is smaller as compared to the respective wall thickness of the portion of the profile's end section which is located adjacent to the covering plate.

The opposed side portions of the sealing within the scope of this application are defined as any two side portions of the sealing facing the jamming member in an opposed direction component. In general, they are not to be construed with respect to their relative distance to the plate-adjoining side of the sealing. For instance, also a side portion at the upper region that is opposed to a side portion at the lower region of the sealing is conceivable. According to a preferred embodiment, the relative distance of the opposed side portions to the plate-adjoining side of the sealing is essentially equivalent.

Preferably, said jamming member is provided with at least two of said tapering portions at each of said opposed side portions of said sealing for further improving the watertightness at the critical region. More preferred, a step-like arrangement of the at least two tapering portions at each side of the sealing is provided. More preferred, three tapering portions are provided on each side portion of the sealing. Preferably, the jamming member is provided with at least one upper protrusion comprising at least one of said tapering portions. More preferred, the upper protrusion projects from an upper center portion of the jamming member. Moreover, said jamming member may provided with at least one lateral projection comprising at least one of said tapering portions.

Preferably, the sealing is provided with corresponding recess structures fitted to the shape of the tapering portions on the jamming member for further improving the pressing force transmission. It is also conceivable, according to another embodiment, that the pressing force is transmitted by means of recess structures formed in the jamming member, in which in this case corresponding projections at the inner circumference of the sealing are engaged.

Preferably, the tapering portions are interconnected via a bridging portion comprising an application surface for applying a force on the jamming member which may then be transferred to the sealing as the pressing force. Advantageously, the application surface may be facing away from the plate-adjoining side of the sealing. In this way, a linear force application on the jamming member directed towards the plate-adjoining side of the sealing can be exploited for exerting the pressing force on the at least two opposed side portions of the sealing and in the transverse direction with respect to the plate-adjoining side of the sealing.

In order to achieve a further improvement of the watertightness along the plate-adjoing side of the sealing, said bridging portion may be adapted to exert a pressing force directly on the plate-adjoining side of the sealing. Accordingly, said bridging portion may comprise an impact surface on the opposed side with respect to said application surface for a transmission of this pressing force. Preferably, this impact surface may be adapted to transmit the force substantially over the total length of the plate-adjoining side of the sealing. Preferably, substantially the total force is transmitted in the direction of the plate-adjoining side of the sealing.

For allowing an advantageous transmission of the pressing force to the sealing, in particular in the transverse direction with respect to the plate-adjoining side of the sealing, the jamming member is preferably disposed in such a way that it displaces at least slightly towards the plate-adjoining side of the sealing when the force is applied on the application surface.

Preferably, the end closure further comprises a capping member. The capping member is preferably provided with an activation surface for transmitting the force to said application surface on said jamming member. More preferred, the activation surface is provided in such a way that it faces the plate-adjoining side of said sealing. Advantageously, the activation surface may be provided on a protrusion on said capping member. Said protrusion may be arranged inside an inner space of said capping member.

Preferably, an inclination towards the cavity of the profile is provided in between said activation surface and said application surface. This inclination can be used to facilitate a force application on the application surface. Preferably, the inclination may be provided on the application surface and/or on the activation surface. For instance, the application surface of the capping member may be provided with an inclination towards the cavity of the profile. Correspondingly, the application surface of the jamming member may be e.g. substantially planar with respect to the length direction of the profile or may also comprise an inclination. Most preferred, the inclination is provided on both surfaces for allowing a smooth and continous guiding of the surfaces on one anther. In this way, an activation force may be advantageously applied on the jamming member by advancing the activation surface of the capping member with respect to the application surface of the jamming member along the inclination resulting in a force application towards the plate-adjoining side of the sealing-loop. Preferably, the inclination has a substantially constant slope.

Preferably, the capping member is provided with exterior walls surrounding the sealing such that the pressing force exerted on the sealing is counteracted by the capping member. For this purpose, the sealing is preferably fitted inside the capping member according to the shape of its exterior circumference. More preferred, at least the portions of the sealing on which the pressing force is exerted are in close contact with the exterior walls of the capping member.

Preferably, the watertight sealing is constituted by a sealing loop. More preferred, the sealing is disposed continously around the end section of the profile for achieving homogenous sealing properties.

A further improvement with respect to the watertightness at the plate-adjoing side of the sealing may be achieved in that the sealing extends into the cavity of the profile, at least on a portion of its plate-adjoining side. Preferably, the jamming member may also extend into the cavity at this particular region for allowing an advantageous transmission of the pressing force also at the portion of the sealing that is extending into the cavity. Additionally or alternatively, a profile may be used with a watertightly attached covering plate extending beyond the end-section of the profile. In this case, a superior water-tightness may be achieved with the sealing and/or jamming member applied at the profile's end section without ranging into the cavity, in particular at the bordering zone with respect to the covering plate.

According to another preferred embodiment, the sealing and the jamming member may be fully or at least partially disposed inside the cavity at the end portion of the profile. In this case, the inner side walls of the profile may be used to counteract the pressing force transmitted from the jamming member.

Preferably, at least one plugging protrusion extending into the cavity of the profile is provided on the jamming member. This may allow a correct positioning of the jamming member with respect to the sealing during installation of the end closure. Preferably, lateral projections of the jamming member are provided with the plugging protrusion. The profile may comprise separate compartment spaces for insertion of the plugging protrusions. The size of the compartment spaces preferably exceeds the size of the plugging protrusions, such that a displacement of the jamming member towards the plate-adjoining side of the sealing is rendered possible during the installation of the end closure. Advantageously, also the bridging portion of the jamming member may extend into the cavity of the profile for further facilitating an inner fixation of the jamming member.

Preferably, the jamming member has a substantially frame-shaped structure. The form of the inner circumference of the sealing is preferably fitted to the outer circumference of the jamming member. More preferred, the jamming member may extend around the total inner circumference of the sealing for allowing an optimal positioning of the jamming member. According to another embodiment, the jamming member may only extend over part of the inner circumference of the sealing for still ensuring a good transmission of the pressing force at the two opposed side portions of the sealing.

According to a preferred utilization of the described profile, the profile contains electronic and/or optical equipment. In particular, the profile may be designed for the waterproof custody of a light barrier or a similar optoelectronic device. Preferably, an electronic enclosure constituted by the profile exhibits an IP value of at least 65.

## Claims

1. An enclosure (1) comprising a hollow profile (2) with an open side portion on which a covering plate (3) is watertightly attached, the profile (2) being provided with at least one end closure (4, 5) comprising a watertight sealing (41) disposed at the end of the profile (2), **characterized in that** a jamming member (40) is provided inside said sealing (41), said jamming member (40) being adapted to exert a pressing force on at least two opposed side portions (71-76) of said sealing (41) acting in a transverse direction (92, 93) with respect to a plate-adjoining side (48) of said sealing (41) which is disposed adjacent to said covering plate (3).

2. The enclosure according to claim 1, **characterized in that** said jamming member (40) is provided with at least one tapering portion (61-66) at each of said opposed side portions (71-76) of said sealing (41) each facing said plate-adjoining side (48) for directing said pressing force in said transverse direction (92, 93).

3. The enclosure according to claim 2, **characterized in that** said jamming member (40) is provided with at least two of said tapering portions (61-66) at each of said opposed side portions (71-76) of said sealing (41).

4. The enclosure according to at least one of the claims 1 to 3, **characterized in that** said jamming member (40) comprises an application surface (70) configured to be applied with a force (91) directed towards the plate-adjoining side (48) of said sealing (41), said application surface (70) facing away from said plate-adjoining side (48).

5. The enclosure according to claim 4, **characterized in that** said tapering portions (61, 62) are interconnected via a bridging portion (55) which is adapted to exert said force (91) on the plate-adjoining side (48) of said sealing (41).

6. The enclosure according to claim 5, **characterized in that** said bridging portion (55) extends into the cavity (20) of the profile (2).

7. The enclosure according to at least one of the claims 4 to 6, **characterized in that** said jamming member (40) is arranged at the end of the profile (2) in such a way that it displaces towards the plate-adjoining side (48) of said sealing (41) when an activation force (90) is applied on said application surface (70).

8. The enclosure according to at least one of the claims 4 to 7, **characterized in that** said end closure (4) further comprises a capping member (42) with an activation surface (80) for transmitting a force to said application surface (70) on said jamming member (40), said activation surface (80) facing said plate-adjoining side (48) of said sealing (41).

9. The enclosure according to claim 8, **characterized in that** an inclination towards the cavity (20) of the profile (2) is provided in between said activation surface (80) and said application surface (70).

10. The enclosure according to at least one of the claims 1 to 9, **characterized in that** a capping member (42) is provided with exterior walls (82-85) surrounding said sealing (41) such that said pressing force exerted on said sealing (41) is counteracted by said capping member (42).

11. The enclosure according to at least one of the claims 2 to 10, **characterized in that** said jamming member (40) is provided with an upper protrusion (60) comprising at least one of said tapering portions (61-66).

12. The enclosure according to at least one of the claims 2 to 11, **characterized in that** said jamming member (40) is provided with at least one lateral projection (65, 66) comprising at least one of said tapering portions (61-66).

13. The enclosure according to at least one of the claims 1 to 11, **characterized in that** at least one plugging protrusion (67, 68) extending into the cavity (20) of the profile (2) is provided on said jamming member (40).

14. The enclosure according to claim 12 and 13, **characterized in that** said plugging protrusion (67, 68) is provided at said lateral projection (65, 66).

15. A device comprising electronic and/or optical components, in particular for a light barrier, **characterized in that** it comprises an enclosure (1) according to at least one of the claims 1 to 14.
